# EUROPEAN PATENT SPECIFICATION

(11) **EP 1 667 235 B1**
(45) Date of publication and mention of the grant of the patent: **15.01.2014**
(21) Application number: 05025976.1
(22) Date of filing: 29.11.2005
(51) Int. Cl.: H01L 27/32, H01L 51/52, H01L 51/00

(54) **Electroluminescence display device**
Elektrolumineszenzanzeigevorrichtung
Dispositif d'affichage électroluminescent

(30) Priority: 01.12.2004 KR 2004100072; 16.12.2004 KR 2004107430
(43) Date of publication of application: 07.06.2006
(73) Proprietor: LG Display Co., Ltd., Seoul 150-721 (KR)
(72) Inventor: Hak, Su Kim, Gangbuk-gu Seoul 142-779 (KR); Hyo, Dae Bae, Dalseo-gu Daegu 704-748 (KR)
(74) Representative: Viering, Jentschura & Partner

(56) References cited:
- EP-A2- 1 286 397
- EP-A2- 1 304 743
- JP-A- 2001 085 162
- JP-A- 2001 217 081
- JP-A- 2001 313 182
- US-A- 5 399 936
- US-A1- 2002 164 415
- US-A1- 2004 140 759

## Description

### BACKGROUND OF THE INVENTION

### Field of the Invention

The present invention relates to an electroluminescence display device, particularly an electroluminescence display device which can reduce the power consumption.

### Description of the Related Art

EP 1 304 743 A2 and EP 1 286 397 A2 disclose OLED displays having a first and second anode structure, primary walls, cathodes and secondary walls.

US 2004/0140759 A1 discloses a polymer organic light emitting diode having barriers to prevent ink from running out of ends of a channel.

Recently, in order to overcome a shortcoming of the cathode ray tube (CRT), various types of flat panel display devices that can reduce the weight and size of CRT have been developed. As flat display device, a liquid crystal display (LCD) device, a field emission display (FED) device, a plasma display panel (PDP) and an organic electroluminescence (EL) display device have been developed and used.

The plasma display panel has an advantage that the structure and manufacturing process are relatively simple, and so it is most preferable for a large size of display surface, but has such shortcomings that the light emitting efficiency and brightness are low and enormous amount of power is consumed.

The liquid crystal display device is mainly used as a display device of the laptop computer, and its demand has been increased. However, the liquid crystal display device has problems that it is difficult to use for a large size of display surface and the power consumption is large due to backlight unit. In addition, the liquid crystal display device has shortcomings that light loss is great due to optical members such as polarized light filter, prism sheet, diffusion sheet and the like, and the viewing angle is narrow.

In comparison, the electroluminescence display device (hereinafter, referred to as "EL display device") is divided into an organic EL display device and an inorganic EL display device according to the material constituting light emitting layer. And, the EL display device itself emits light, and so the response time is short, the light emitting efficiency and the brightness are high, and the viewing angle is wide. Compared with the organic EL display device, the inorganic EL display device has shortcomings that the power consumption is large, the high brightness cannot be obtained and various lights of R (red), G (green) and B (blue) cannot be emitted. On the other hand, the organic EL display device is driven with several tens of low direct current and has a rapid response time. In addition, the organic EL display device can obtain high brightness and can emit various lights of R, G and B, and so is suitable for next generation of flat panel display device.

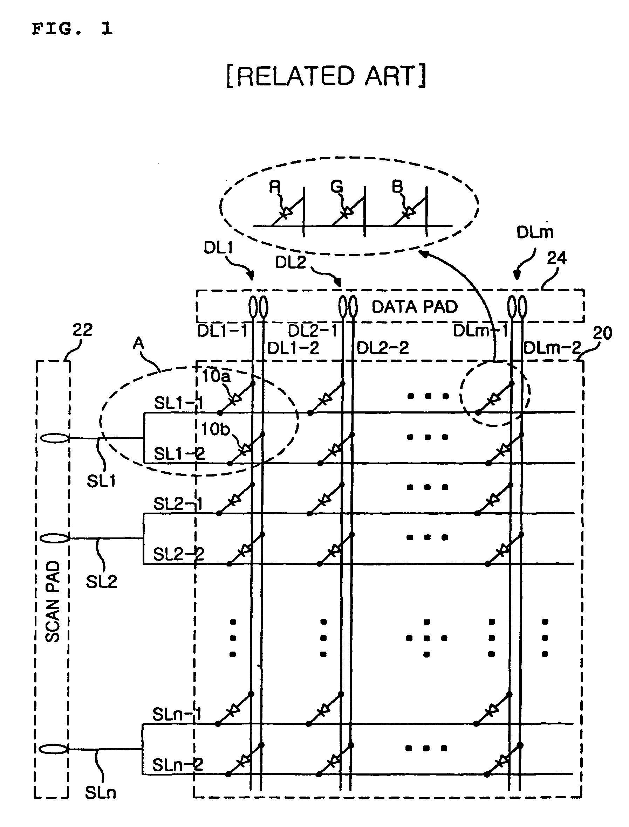

FIG. 1 is a view showing schematically an organic EL display device.

Referring to FIG. 1, the organic EL display device has an organic EL display panel 20 comprising anode columns DL1 to DLm, cathodes SL1 to SLn overlying the anode columns, and first and second organic EL diodes 10a and 10b formed at overlying sections of the anode columns and the cathodes and disposed in a matrix.

Also, the organic EL display device has a non display area with a data pad 24 to which the anode columns DL1 to DLm are connected via data lines (not shown) and a scan pad 22 to which the cathode SL1 to SLn are connected via scan lines (not shown).

The data pad 24 and the scan pad 22 are connected to a tape carrier package (TCP; not shown) in which a data driving section (not shown) for generating data signal and a scan driving section (not shown) for generating scan signal are provided.

Data signal transmitted from the data driving section is supplied to the anode columns DL1 to DLm via the data pad 24 and the data lines, and scan signal transmitted from the scan driving section is supplied to the cathodes SL1 to SLn via the scan pad 22 and the scan lines.

Here, each anode column (for example, DL1) comprises first and second anodes DL1-1 and DL1-2 adjacent to each other, each cathode (for example, SL1) is divided into first and second sub cathodes SL1-1 and SL1-2 spaced from each other.

Accordingly, the scan pulse supplied from the scan driving section to the cathode (for example, SL1) is supplied simultaneously to the first and second sub cathodes SL1-1 and SL1-2.

In a first organic electroluminescence diode 10a, an anode electrode is connected to the first anode DL1-1 of the anode column DL1, and a cathode electrode is connected to the first sub cathode SL1-1 of the cathode SL1. Also, in a second organic electroluminescence diode 10b, an anode electrode is connected to the second anode DL1-2 of the anode column DL1, and a cathode electrode is connected to the second sub cathode SL1-2 of the cathode line SL1

Therefore, though the scan pulse is supplied to the cathode SL1 from the scan driving section, the data driving section can drive the first and second organic electroluminescence diodes 10a and 10b independently.

The above operation is performed in all anode columns DL1 to DLm and cathodes SL1 to SLn.

When the negative scan pulse is supplied to the cathodes SL1 to SLn to which the cathode electrodes of the first and second organic electroluminescence diodes 10a and 10b are connected and the positive data pulse is supplied to the first anode (for example, DL1-1) of each anode column (for example, DL1) to which the anode electrode of the first organic electroluminescence diode 10a is connected and the second anode DL1-2 of each anode column to which the anode electrode of the second organic electroluminescence diode 10b is connected, the current is flown by forward bias, and so the first and second organic electroluminescence diodes emit light.

Also, each of the first and second organic electroluminescence diodes 10a and 10b is formed with a first EL cell R having red fluorescent material, a second EL cell G having green fluorescent material, and a third EL cell B having blue fluorescent material.

Each organic electroluminescence diode corresponding to one pixel of the organic EL display device emits a color image for one pixel by the combination of the first EL cell R, the second cell G and the third EL cell B.

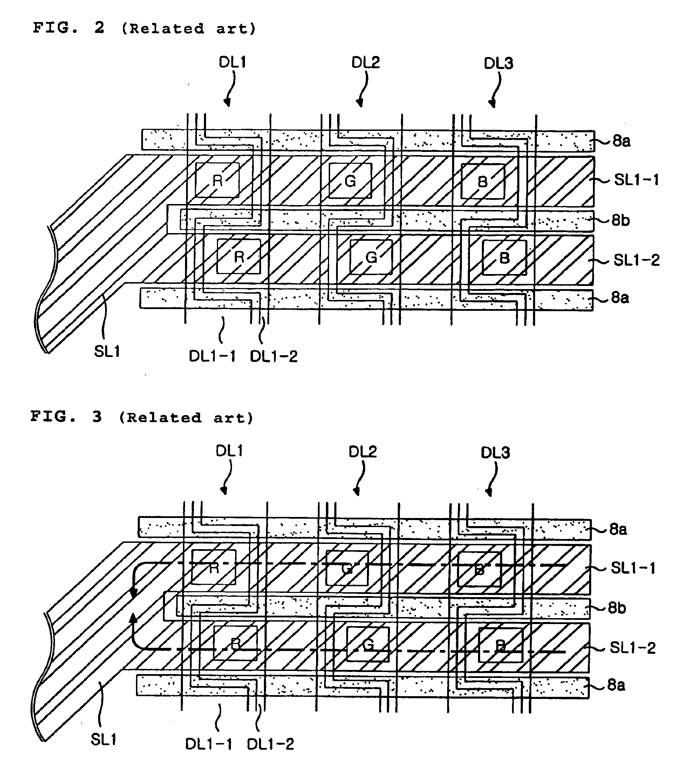

FIG. 2 is a detail view of "A" section in FIG. 1. For convenience's sake, only three anode columns and one cathode are shown in FIG. 2.

In FIG. 2, the organic EL display device comprises the anode columns DL1, DL2, DL3, the cathode SL1 overlying the anode columns, a first EL cell R, a second cell G, and a third EL cell B, formed at overlying areas of the anode columns DL1, DL2 and DL3 and the cathode SL1, and walls 8a and a subsidiary wall 8b overlying the anode columns DL1, DL2, DL3 to be parallel with the cathode SL1.

As described above, each anode column (for example, DL1) comprises the first and second anodes DL1-1 and DL1-2 adjacent to each other, and a section of the cathode SL1 (that is, a section corresponding to the emitting area) is divided into the first and second sub cathodes SL1-1 and SL1-2 spaced from each other by the subsidiary wall 8b.

Accordingly, two emitting light areas R are formed at an area formed by overlying one anode column (for example, DL1) and one cathode SL1.

Here, the walls 8a are extended to a non display (non-emitting) area, but the subsidiary wall 8b is formed only on the EL cell array area (active region). After forming the walls, organic emitting material is deposited through a mask on the EL cell array area of the substrate on which the walls 8a and the subsidiary wall 8b are formed, and so the first EL cell R, the second cell G and the third EL cell B are formed. Thereafter, the cathode SL1 is formed by depositing conductive material on an entire structure.

When the negative scan pulse is supplied to the cathode SL1, i.e., the first and second sub cathodes SL1-1 and SL1-2 from the scan driving section, and the positive data pulse is supplied to one anode (for example, DL1-1) of the anode column DL1 from the data driving section 22 at the same time, the current is flown to the cathode SL1 through the current path as shown in FIG. 3, and so the corresponding cell emits light.

In such organic EL display device, if the data current for driving the pixels in full white is applied to the first and second sub cathodes SL1-1 and SL1-2 through the anodes or if a relative large data current is applied, the first and second sub cathodes SL1-1 and SL1-2 may not withstand load of the supplied the current.

At this time, since the scan pulse is supplied to two sub cathodes SL1-1 and SL1-2 through the cathode SL1 formed at the non-emitting area, it is possible to form the cathodes with half of the number of the sub cathodes, and so each cathode having larger width can be formed on the non-emitting area.

Therefore, line resistance of each cathode SL1 to SLn at the non-emitting area is decreased, and the power consumption of the organic EL display device is decreased due to decrease of the line resistance of each of the cathodes SL1 to SLn.

However, though the line resistance of the cathodes SL1 to SLn is decreased, the line resistance of the first and second sub cathodes SL1-1, SL1-2 to SLn-1, SLn-2 formed on the EL cell array area is not decreased, and so this method has a limit in decreasing the power consumption of the organic EL display device.

### SUMMARY OF THE INVENTION

The invention provides an electroluminescent device according to claim 1. Further embodiments of the invention are described in the dependent claims.

An object of the present invention is to provide an organic electroluminescence display device which can reduce the power consumption.

For achieving the above object, an electroluminescent display device according to the present invention comprises a plurality of anode columns provided on a substrate, each anode column comprising a first anode and a second anode, wherein the first and second anodes are disposed adjacent to each other such that respective emitting areas of the first and second anodes are arranged alternately along a respective anode column; a plurality of primary walls positioned substantially perpendicular to the plurality of anode columns; a plurality of cathodes, wherein a cathode is provided between two of the primary walls so as to contact the respective emitting areas of the first and second anodes; and a plurality of secondary walls positioned between two adjacent primary walls.

Each of the plurality of secondary walls extends along a length of a pixel or one sub-pixel, and a connection portion is formed between each set of adjacent pixels in a row of the device.

In the device according to the present invention, each of the plurality of secondary walls comprises an extension portion formed at at least one end thereof, each extension portion is configured to inhibit interference between adjacent pixels.

### BRIEF DESCRIPTION OF THE DRAWINGS

The present invention will be more clearly understood from the detailed description in conjunction with the following drawings.
FIG. 1 is a view showing schematically an organic electroluminescence display device;
FIG. 2 is a detail view of "A" section in FIG. 1;
FIG. 3 is a view showing a current path formed in the organic electroluminescence display device;
FIG. 4 is a view showing schematically the organic electroluminescence display device according to the present invention;
FIG. 5a is a view showing partially the organic electroluminescence display device according to the first embodiment of the present invention;
FIG. 5b is a sectional view taken along the line 5b-5b in FIG. 5a;
FIG. 5c is a sectional view taken along the line 5c-5c in FIG. 5a;
FIG. 6 is a view showing a current path formed in the organic electroluminescence display device according to the first embodiment of the present invention;
FIG. 7a is a view showing partially the organic electroluminescence display device according to the second embodiment of the present invention;
FIG. 7b is a sectional view taken along the line 7b-7b in FIG. 7a;
FIG. 8 is a view showing partially the organic electroluminescence display device according to the third embodiment of the present invention;
FIG. 9 is a view showing a current path formed in the organic electroluminescence display device according to the second and third embodiments of the present invention;
FIG. 10 is a view showing partially the organic electroluminescence display device according to the fourth embodiment of the present invention;
FIG. 11 is a view showing a current path formed in the organic electroluminescence display device according to the fourth embodiment of the present invention;
FIG. 12 is a view showing partially the organic electroluminescence display device according to the fifth embodiment of the present invention;
FIG. 13 is a view showing partially the organic electroluminescence display device according to the sixth embodiment of the present invention; and
FIG. 14 is a view showing a current path formed in the organic electroluminescence display device according to the sixth embodiment of the present invention.

### DETAILED DESCRIPTON OF THE INVENTION

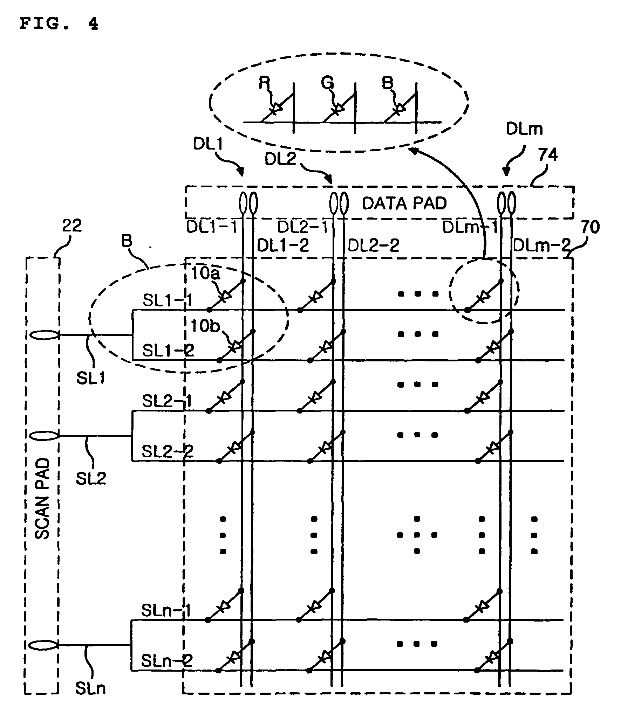

Hereinafter, the preferred embodiments of the present invention will be described in detail with reference to FIG. 4 to FIG. 14.

FIG. 4 is a view showing schematically the organic electroluminescence display device (hereinafter, referred to as "organic EL display device") according to the present invention. The entire structure of the organic EL display device according to the present invention is similar to that of the organic EL display device shown in FIG. 1. Accordingly, a description on the similar sections of the two devices is omitted.

Also, for convenience's sake, only three anode columns and one cathode are described and shown in the drawings below.

### [The first embodiment]

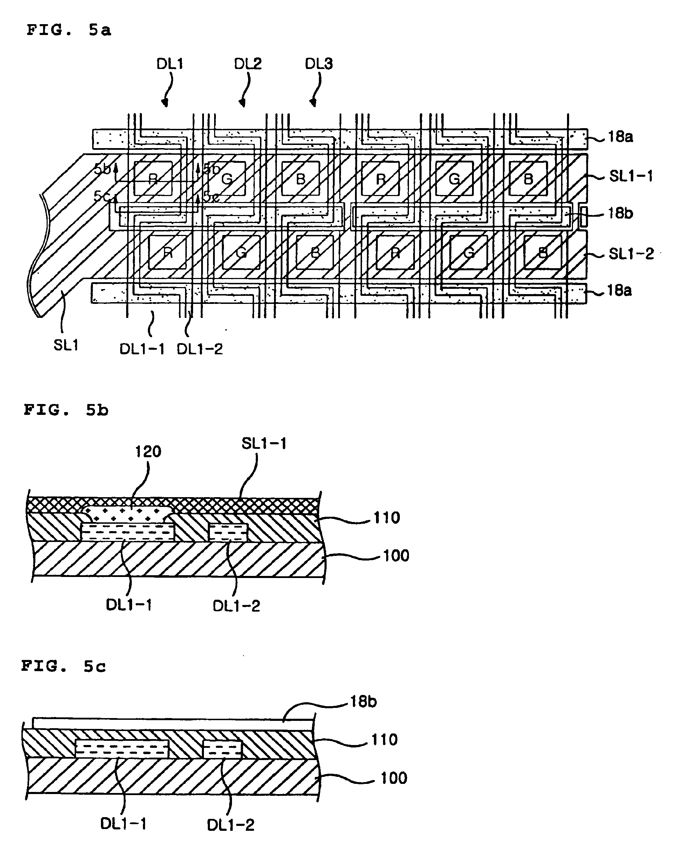

FIG. 5a is a view showing partially the organic EL display device according to the first embodiment of the present invention, and shows in detail the section "B" in FIG. 4.

Referring to FIG. 5a, the organic EL display device according to the first embodiment of the present invention comprises anode columns DL1, DL2 and DL3, a cathode SL1 overlying the anode columns, and primary walls 18a and a secondary wall 18b which overlie the anode columns DL1, DL2 and DL3 and are parallel with the cathode SLI.

Here, a section of the cathode SL1 (that is, a section corresponding to the active region) is divided into first and second sub cathodes SL1-1 and SL1-2 by the secondary wall 18b, and so two individual cells are formed on an overlying area of one anode column DL1 and one cathode SL1. Also, although the primary walls 18a are extended to a non display area (non emitting area), but the secondary wall 18b is formed on only cell array area (active region).

In this embodiment, the secondary wall 18b dividing the cathode is divided into a plurality of unit secondary walls, each unit secondary wall corresponding to the first to third sub-pixels (EL cells) R, G and B constituting one pixel.

Due to the above structure, the first and second sub cathodes SL1-1 and SL1-2 are connected to each other at an area between the adjacent unit secondary walls, and so the first and second sub cathodes SL1-1 and SL1-2 have larger width, and the resistance of the sub cathodes SL1-1 and SL1-2 can be reduced.

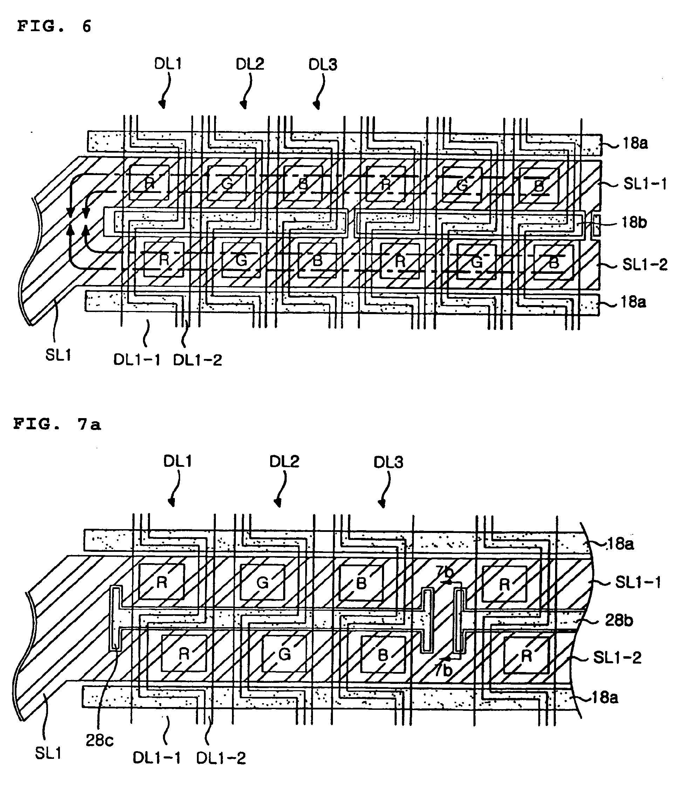

Accordingly, the current supplied to the first and second sub cathodes SL1-1 and SL1-2 is flowed easily to the cathode SL1 by forming the current path shown in FIG. 6 so that the power consumption of the organic EL display device can be decreased.

On the other hand, FIG. 5b is a sectional view taken along the line 5b-5b in FIG. 5a and FIG. 5c is a sectional view taken along the line 5c-5c in FIG. 5a. FIG. 5b and FIG. 5c show a relation between the anode columns DL1 (the first and second anodes DL1-1 and DL1-2) formed on a substrate 100 and the first sub cathode SL1-1.

Reference numerals "110" and "120" which are not described above indicate an insulating layer and an organic EL layer, respectively.

### [The second embodiment]

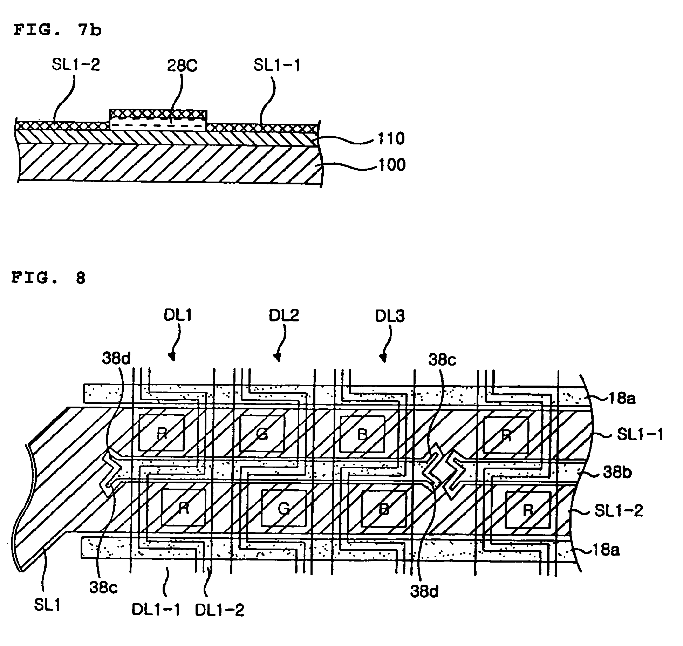

FIG. 7a is a view showing partially the organic EL display device according to the second embodiment of the present invention, and shows in detail the section "B" in FIG. 4. FIG. 7b is a sectional view taken along the line 7b-7b in FIG. 7a.

In FIG. 7a, the organic EL display device according to the second embodiment of the present invention comprises the anode columns DL1, DL2 and DL3, the cathode SL1 overlying the anode columns, and primary walls 18a and a secondary wall 28b which overlie the anode columns and are parallel with the cathode SLI.

Here, a section of the cathode SL1 (that is, a section corresponding to the active region) is divided into first and second sub cathodes SL1-1 and SL1-2 by the secondary wall 28b, and so two individual cells are formed on an overlying area of one anode column (for example, DL1) and one cathode SL1. Also, although the primary walls 18a are extended to the non display region, the secondary wall 28b is formed on only cell array area.

In this embodiment, the secondary wall 28b dividing the cathode SL1 is divided into a plurality of unit secondary walls, each unit secondary wall corresponding to the first to third sub-pixels (EL cells) R, G and B constituting one pixel.

On the other hand, each unit secondary wall corresponding to the pixel comprising the first to third sub-pixels (EL cells) R, G and B has at least one extension portion 28c formed on at least one end thereof. The extension portion 28c is parallel with the anode columns DL1 and DL3. On the other hand, FIG. 7a shows that two extension portions 28c are formed on both ends of each unit secondary wall.

Due to the above structure, the first and second sub cathodes SL1-1 and SL1-2 are connected to each other at an area between the adjacent unit secondary walls, and so the first and second sub cathodes SL1-1 and SL1-2 have larger width, and thus the resistance of the sub cathodes SL1-1 and SL1-2 can be reduced.

Also, each unit secondary wall has the extension portion 28c at one end or both ends thereof, and so interference phenomenon generated between the adjacent pixels when the EL cells emit light can be reduced, and thus an image quality displayed on the organic EL display panel is enhanced.

### [The third embodiment]

FIG. 8 is a view showing partially the organic EL display device according to the third embodiment of the present invention, and shows in detail the section "B" in FIG. 4.

The structure of the organic EL display device according to this embodiment is the same as that of the organic EL display device according to the first embodiment shown in FIG. 6. Only, a first extension portion 38c and a second extension portion 38d are formed on at least one end of each unit secondary wall of a secondary wall 38b, with a certain angle to the anode columns DL1 and DL2.

Here, the first extension portion 38c is longer than the second extension portion 38d. Also, the first extension portion 38c of each unit secondary wall is adjacent to the second extension portion 38d and is parallel with the first extension portion 38c of the adjacent unit secondary wall.

Also, the second extension portion 38d of each unit secondary wall is adjacent to the first extension portion 38c and parallel with the second extension portion 38d of the adjacent unit secondary wall.

Due to the above structure, the first and second sub cathodes SL1-1 and SL1-2 are connected to each other at a region between the adjacent unit secondary walls, and so the first and second sub cathodes SL1-1 and SL1-2 have larger width, and the resistance of the first and second sub cathodes SL1-1 and SL1-2 can be reduced. Also, since each unit secondary wall 38b has the extension portions 38c and 38d formed at one end or both ends thereof, interference phenomenon generated between the adjacent pixels when the EL cells emit light can be reduced, and so an image displayed on the organic EL display panel is enhanced.

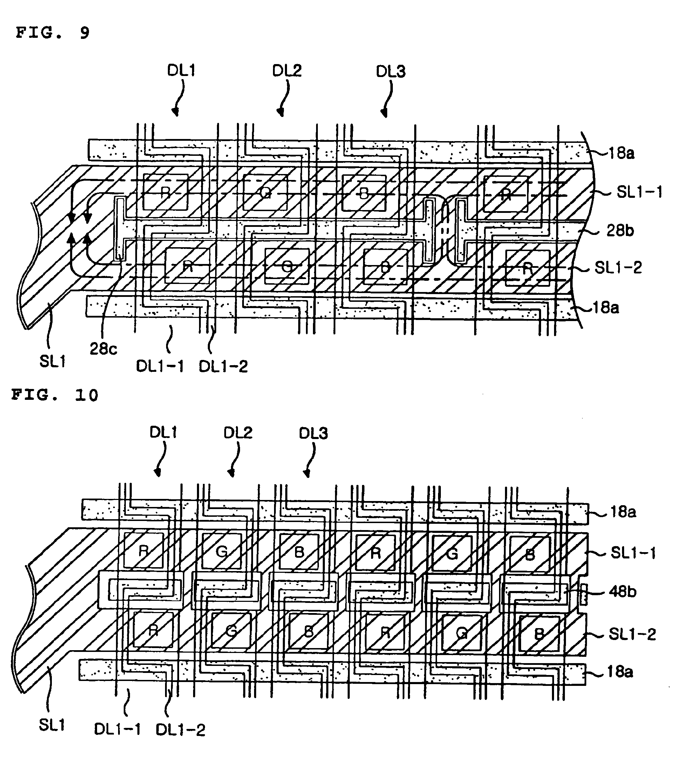

In the organic EL display device according to the second and third embodiments of the present invention, the current supplied to the first and second sub cathodes SL1-1 and SL1-2 supplied through the anode can be flowed to the cathode SL1 by forming the current path shown in FIG. 9 so that the power consumption of the organic EL display device can be decreased.

### [The fourth embodiment]

FIG. 10 is a view showing partially the organic EL display device according to the fourth embodiment of the present invention, and shows in detail the section "B" in FIG. 4.

In FIG. 10, the organic EL display device according to the fourth embodiment of the present invention comprises the anode columns D1, D2 and D3, the cathode SL1 overlying the anode columns, and the primary walls 18a and a secondary wall 48b which overlie the anode columns D1, D2 and D3 and are parallel with the cathode SL1.

Like the first embodiment, a section of the cathode SL1 (that is, a section corresponding to the active region) is divided into first and second sub cathodes SL1-1 and SL1-2 by the secondary wall 48b, and so two individual cells are formed on an overlying area of one anode column DL1 and one cathode SL1. Also, although the primary walls 18a are extended to a non display region, but the secondary wall 48b is formed on only cell array region.

In this embodiment, the secondary wall 48b dividing the cathode is divided into a plurality of unit secondary walls, each unit secondary wall corresponding to each of the first to third sub-pixels (EL cells) R, G and B constituting one pixel.

Due to the above structure, the first and second sub cathodes SL1-1 and SL1-2 are connected to each other at an area between the adjacent unit secondary walls, and so the first and second sub cathodes SL1-1 and SL1-2 have larger width, and the resistance of the sub cathodes can be reduced.

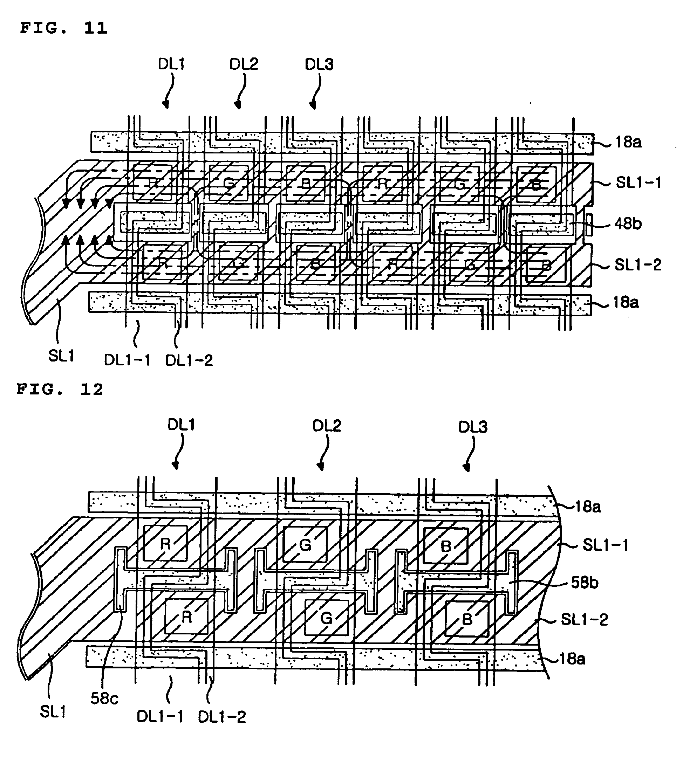

Accordingly, the current supplied to the first and second sub cathodes SL1-1 and SL1-2 through the anode is flowed easily to the cathode SL1 though the current path shown in FIG. 11 so that the power consumption of the organic EL display device can be decreased.

### [The fifth embodiment]

FIG. 12 is a view showing partially the organic EL display device according to the fifth embodiment of the present invention, and shows in detail a section "B" in FIG. 4.

In FIG. 12, the structure of the organic EL display device according to this embodiment is same as that of the organic EL display device according to the fourth embodiment shown in FIG. 10. Only, an extension portion 58c is formed on at least one end of each unit secondary wall of the secondary wall 58b. That is, each unit secondary wall corresponds to each sub-pixel (EL cell), and the extension portion 58c is extended and parallel with the anode columns DL1, DL2 and DL3. On the other hand, FIG. 12 shows that two extension portions 58c are formed on both ends of each unit secondary wall.

Due to the above structure, the first and second sub cathodes SL1-1 and SL1-2 are connected to each other at an area between the adjacent unit secondary walls, and so the first and second sub cathodes SL1-1 and SL1-2 have larger width, and the resistance of the sub cathodes can be reduced. Also, since each unit secondary wall has the extension portions 58c formed at one end or both ends thereof, interference phenomenon generated between the adjacent sub-pixels (R and G, G and B) when the EL cells emit light can be reduced, and so an image displayed on the organic EL display panel is enhanced.

### [The sixth embodiment]

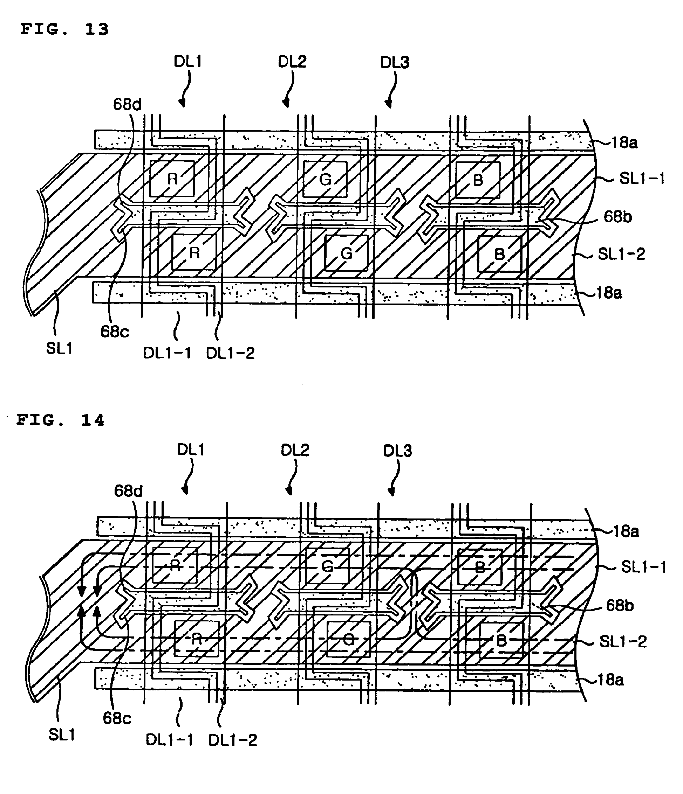

FIG. 13 is a view showing partially the organic EL display device according to the sixth embodiment of the present invention, and shows in detail the section "B" in FIG. 4.

The structure of the organic EL display device according to this embodiment is same as that of the organic EL display device according to the fourth embodiment shown in FIG. 10. Only, extension portions 68c and 68d are formed on at least one end of each unit secondary wall of a secondary wall 68b. That is, each unit secondary wall corresponds to each sub-pixel (EL cell), and the first and second extension portions 68c and 68d are extended with a certain angle to the anode columns DL1, DL2 and DL3.

Here, the first extension portion 68c is longer than the second extension portion 68d. Also, the first extension portion 68c of each unit secondary wall is adjacent to the second extension portion 68d and parallel with the first extension portion 68c of the adjacent unit secondary wall.

Also, the second extension portion 68d of each unit secondary wall is adjacent to the first extension portion 68c and parallel with the second extension portion 68d of the adjacent unit secondary wall.

Due to the above structure, the first and second sub cathodes SL1-1 and SL1-2 are connected to each other at an area between the adjacent unit secondary walls, and so the first and second sub cathodes SL1-1 and SL1-2 have larger width, and the resistance of the sub cathodes can be reduced. Also, since each unit secondary wall has the extension portions 68c and 68d at one end or both ends thereof, interference phenomenon generated between the adjacent sub-pixels when the EL cells emit light can be reduced, and so an image displayed on the organic EL display panel is enhanced.

In the organic EL display devices according to the fifth and sixth embodiments of the present invention, the current supplied to the first and second sub cathodes SL1-1 and SL1-2 through the anode can be flowed to the cathode SL1 by forming the current path shown in FIG. 14 so that the power consumption of the organic EL display device can be decreased.

In the organic EL display device as described above, each cathode is divided into two sub cathodes at the active region by the secondary wall, and the two sub cathodes are connected to each other at an area between the adjacent unit secondary walls, and so the cathode formed on the emitting area has larger width. Accordingly, the resistance of the cathode is remarkably reduced so that the power consumption of the organic EL display device can be decreased.

Also, due to the extensions which are formed at the end(s) of each unit secondary wall and are extended in parallel or with a certain angle to the anodes, the interference between the adjacent pixels or sub-pixels can be reduced so that the image quality of the organic EL display device is enhanced.

The preferred embodiments of the present invention have been described for illustrative purposes, and those skilled in the art will appreciate that various modifications, additions, and substitutions are possible, without departing from the scope of the present invention as disclosed in the accompanying claims.

## Claims

1. An electroluminescent device, comprising:
a plurality of anode columns (DL1, ..., DLm) provided on a substrate (100), each anode column comprising a first anode (DL1-1) disposed on an odd row and a second anode (DL1-2) disposed on an even row, wherein the first and second anodes are disposed adjacent to each other such that respective emitting areas of the first and second anodes are arranged alternately along a respective anode column;
a plurality of primary walls (18a) which overlie the anode columns positioned substantially perpendicular to the plurality of anode columns;
a plurality of secondary walls (18b) which overlie the anode columns positioned between respective emitting areas of the first and second anodes of each anode column and arranged in parallel with the two adjacent primary walls (18a) to separate at least one first row sub-pixel from a corresponding at least one second row sub-pixel positioned between the two adjacent primary walls (18a);
a plurality of cathodes (SL1, ..., SLn), wherein a cathode is provided between two of the primary walls (18a) so as to contact the respective emitting areas of the first and second anodes (DL1-1, DL1-2) and divided into a first sub cathode (SL1-1) disposed on the odd row and a second sub cathode (SL1-2) disposed on the even row by the secondary walls (18b); and
**characterized in that**:
the plurality of secondary walls (18b) are each shorter in length than the plurality of primary walls (18a) and **in that** the first sub cathode (SL1-1) and the second sub cathode (SL1-2) are connected to a connection portion formed between each set of adjacent pixels in a row of the device.

2. The device of claim 1, wherein each of the plurality of secondary walls (18b) extends along a length of a pixel.

3. The device of claim 1, wherein each of the plurality of secondary walls (18b) extends along a length of one sub-pixel.

4. The device of claim 1, wherein each of the plurality of secondary walls (28b) comprises an extension portion (28c) formed at at least one end thereof.

5. The device of claim 4, wherein each extension portion comprises first and second extension portions (38c, 38d) which extend from the at least one end of its respective secondary wall (38b).

6. The device of claim 5, wherein each of the first and second extension portions (38c, 38d) extends at a predetermined angle from its respective secondary wall (38b).

7. The device of claim 6, wherein each secondary wall (28b) comprises an extension portion (28c) formed at each end thereof.

8. The device of claim 7, wherein the first extension portions (38c) of each secondary wall (38b) extend parallel to one another, and the second extension portions (38d) of each secondary wall (38b) extend parallel to one another.

9. The device of claim 8, wherein the first and second extension portions (38c, 38d) of each secondary wall (38b) are non-parallel.

10. The device of claim 8, wherein the first extension portion (68c) is longer than the second extension portion (68d).

11. The device of claim 6, wherein each of the first and second extension portions extends substantially perpendicular to its respective secondary wall.

12. The device of claim 1, wherein the device is an organic electroluminescent device.

13. The device of claim 1, wherein the first and second sub cathode (SL1-1, SL1-2) are commonly coupled to a scan line through the connection portion.

## Patentansprüche

1. Elektrolumineszenz-Vorrichtung, aufweisend:
eine Mehrzahl von auf einem Substrat (100) bereitgestellten Anodenspalten (DL1, ..., DLm), jede Anodenspalte aufweisend eine erste Anode (DL1-1), die in einer ungeradzahligen Zeile angeordnet ist, und eine zweite Anode (DL1-2), die in einer geradzahligen Zeile angeordnet ist, wobei die erste Anode und die zweite Anode derart benachbart zueinander angeordnet sind, dass entsprechende emittierende Bereiche der ersten Anode und der zweiten Anode entlang einer entsprechenden Anodenspalte abwechselnd angeordnet sind;
eine Mehrzahl von Primärwänden (18a), die auf der Anodenspalte aufliegen und die im Wesentlichen senkrecht zu der Mehrzahl von Anodenspalten angeordnet sind;
eine Mehrzahl von Sekundärwänden (18b), die auf der Anodenspalte aufliegen und die zwischen entsprechenden emittierenden Bereichen der ersten Anode und der zweiten Anode jeder Anodenspalte angeordnet sind und derart parallel zu den beiden benachbarten Primärwänden (18a) angeordnet sind, dass sie mindestens ein Erste-Zeile-Subpixel von einem entsprechenden mindestens einen Zweite-Zeile-Subpixel trennen, die zwischen den beiden benachbarten Primärwänden (18a) angeordnet sind;
eine Mehrzahl von Kathoden (SL1, ..., SLn), wobei eine Kathode derart zwischen zwei der Primärwände (18a) bereitgestellt ist, dass sie die entsprechenden emittierenden Bereiche der ersten Anode (DL1-1) und zweiten Anode (DL1-2) kontaktiert, und mittels der Sekundärwände (18b) in eine erste Teilkathode (SL1-1), die in der ungeradzahligen Zeile angeordnet ist, und eine zweite Teilkathode (SL1-2), die in der geradzahligen Zeile angeordnet ist, unterteilt ist, und
**dadurch gekennzeichnet, dass**
die Mehrzahl von Sekundärwänden (18b) jeweils in der Länge kürzer sind als die Mehrzahl von Primärwänden (18a) und dass die erste Teilkathode (SL1-1) und die zweite Teilkathode (SL1-2) mit einem Verbindungsbereich verbunden sind, der zwischen jedem Satz von benachbarten Pixeln in einer Zeile der Vorrichtung gebildet ist.

2. Vorrichtung gemäß Anspruch 1, wobei sich jede der Mehrzahl von Sekundärwänden (18b) entlang einer Länge eines Pixels erstreckt.

3. Vorrichtung gemäß Anspruch 1, wobei sich jede der Mehrzahl von Sekundärwänden (18b) entlang einer Länge eines Subpixels erstreckt.

4. Vorrichtung gemäß Anspruch 1, wobei jede der Mehrzahl von Sekundärwänden (28b) einen Verlängerungsbereich (28c) aufweist, der an mindestens einem ihrer Enden gebildet ist.

5. Vorrichtung gemäß Anspruch 4, wobei jeder Verlängerungsbereich einen ersten Verlängerungsbereich (38c) und einen zweiten Verlängerungsbereich (38d) aufweist, die sich von dem mindestens einen Ende ihrer entsprechenden Sekundärwand (38b) erstrecken.

6. Vorrichtung gemäß Anspruch 5, wobei sich jeder erste Verlängerungsbereich (38c) und zweite Verlängerungsbereich (38d) in einem vorher festgelegten Winkel von seiner entsprechenden Sekundärwand (38b) erstreckt.

7. Vorrichtung gemäß Anspruch 6, wobei jede Sekundärwand (28b) einen Verlängerungsbereich (28c) aufweist, der an jedem ihrer Enden gebildet ist.

8. Vorrichtung gemäß Anspruch 7, wobei sich die ersten Verlängerungsbereiche (38c) von jeder Sekundärwand (38b) parallel zueinander erstrecken und sich die zweiten Verlängerungsbereiche (38d) von jeder Sekundärwand (38b) parallel zueinander erstrecken.

9. Vorrichtung gemäß Anspruch 8, wobei der erste Verlängerungsbereich (38c) und der zweite Verlängerungsbereich (38d) von jeder Sekundärwand (38b) nicht parallel sind.

10. Vorrichtung gemäß Anspruch 8, wobei der erste Verlängerungsbereich (68c) länger als der zweite Verlängerungsbereich (68d) ist.

11. Vorrichtung gemäß Anspruch 6, wobei sich jeder der ersten Verlängerungsbereiche und der zweiten Verlängerungsbereiche im Wesentlichen senkrecht zu seiner jeweiligen Sekundärwand erstreckt.

12. Vorrichtung gemäß Anspruch 1, wobei die Vorrichtung eine organische Elektrolumineszenz-Vorrichtung ist.

13. Vorrichtung gemäß Anspruch 1, wobei die erste Teilkathode (SL1-1) und die zweite Teilkathode (SL1-2) durch den Verbindungsbereich gemeinsam mit einer Abtastleitung gekoppelt sind.

## Revendications

1. Dispositif électroluminescent, comprenant :
une pluralité de colonnes d'anodes (DL1, ..., DLm) prévues sur un substrat (100), chaque colonne d'anodes comprenant une première anode (DL1-1) disposée sur une rangée impaire et une seconde anode (DL1-2) disposée sur une rangée paire, dans lequel les première et seconde anodes sont disposées de façon adjacente l'une à l'autre de sorte que des zones d'émission respectives des première et seconde anodes sont agencées de façon alternée le long d'une colonne d'anodes respectives ;
une pluralité de parois primaires (18a), qui recouvrent les colonnes d'anodes, positionnées de façon sensiblement perpendiculaire à la pluralité de colonnes d'anodes ;
une pluralité de parois secondaires (18b), qui recouvrent les colonnes d'anodes, positionnées entre des zones d'émission respectives des première et seconde anodes de chaque colonne d'anodes et agencées en parallèle avec les deux parois primaires adjacentes (18a) pour séparer au moins un sous-pixel de première rangée à partir d'au moins un sous-pixel de seconde rangée correspondant positionné entre les deux parois primaires adjacentes (18a) ;
une pluralité de cathodes (SL1, ..., SLn), dans lequel une cathode est prévue entre deux des parois primaires (18a) afin d'entrer en contact avec les zones d'émission respectives des première et seconde anodes (DL1-1, DL1-2) et divisée en une première sous-cathode (SL1-1) disposée sur la rangée impaire et une seconde sous-cathode (SL1-2) disposée sur la rangée paire par les parois secondaires (18b) ; et
**caractérisé en ce que** :
la pluralité de parois secondaires (18b) sont chacune plus courtes en longueur que la pluralité de parois primaires (18a) et **en ce que** la première sous-cathode (SL1-1) et la seconde sous-cathode (SL1-2) sont connectées à une partie de connexion formée entre chaque jeu de pixels adjacents dans une rangée du dispositif.

2. Dispositif selon la revendication 1, dans lequel chacune parmi la pluralité de parois secondaires (18b) s'étend sur une longueur d'un pixel.

3. Dispositif selon la revendication 1, dans lequel chacune parmi la pluralité de parois secondaires (18b) s'étend sur une longueur d'un sous-pixel.

4. Dispositif selon la revendication 1, dans lequel chacune parmi la pluralité de parois secondaires (28b) comprend une partie de prolongement (28c) formée à au moins une extrémité de celle-ci.

5. Dispositif selon la revendication 4, dans lequel chaque partie de prolongement comprend des première et seconde parties de prolongement (38c, 38d) qui s'étendent à partir de l'au moins une extrémité de sa paroi secondaire respective (38b).

6. Dispositif selon la revendication 5, dans lequel chacune des première et seconde parties de prolongement (38c, 38d) s'étend à un angle prédéterminé à partir de sa paroi secondaire respective (38b).

7. Dispositif selon la revendication 6, dans lequel chaque paroi secondaire (28b) comprend une partie de prolongement (28c) formée à chaque extrémité de celle-ci.

8. Dispositif selon la revendication 7, dans lequel les premières parties de prolongement (38c) de chaque paroi secondaire (38b) s'étendent parallèlement les unes aux autres, et les secondes parties de prolongement (38d) de chaque paroi secondaire (38b) s'étendent parallèlement les unes aux autres.

9. Dispositif selon la revendication 8, dans lequel les première et seconde parties de prolongement (38c, 38d) de chaque paroi secondaire (38b) ne sont pas parallèles.

10. Dispositif selon la revendication 8, dans lequel la première partie de prolongement (68c) est plus longue que la seconde partie de prolongement (68d).

11. Dispositif selon la revendication 6, dans lequel chacune des première et seconde parties de prolongement s'étend de façon sensiblement perpendiculaire à sa paroi secondaire respective.

12. Dispositif selon la revendication 1, dans lequel le dispositif est un dispositif électroluminescent organique.

13. Dispositif selon la revendication 1, dans lequel les première et seconde sous-cathodes (SL1-1, SLI-2) sont communément couplées à une ligne de balayage à travers la partie de connexion.
